# EUROPEAN PATENT APPLICATION

(11) **EP 4 714 713 A1**
(43) Date of publication of application: **25.03.2026**
(21) Application number: 24201432.2
(22) Date of filing: 19.09.2024
(51) Int. Cl.: B60K 35/22, B60K 35/29, B60K 35/65, B60K 35/81, G02F 1/13, G02F 1/13357, H10K 59/80

(54) **SYSTEM COMPRISING A DISPLAY DEVICE AND CORRESPONDING METHOD**

(71) Applicant: Valeo Comfort and Driving Assistance, 94000 Créteil (FR)
(72) Inventor: SCHMITT, Martin, 96476 Bad Rodach (DE)
(74) Representative: Delplanque, Arnaud

(57) **Abstract**

A system comprises:
- a display device (8) capable of generating a light beam having an adjustable angular extension;
- a control unit configured to control the angular extension of the light beam depending on information relating to at least one occupant at least possibly viewing the display device (8).

## Description

### TECHNICAL FIELD OF THE INVENTION

The invention relates to the technical field of display systems.

More precisely the invention relates to a system comprising a display device and to a corresponding method.

### BACKGROUND INFORMATION AND PRIOR ART

Nowadays, some motor vehicles are equipped with a display device generating a light beam mainly directed to the location of the passenger compartment where the front passenger is seated, *i.e.* a display device dedicated to the front passenger.

Such a display device may for instance be placed in a central portion of the dashboard (possibly combined with another display device, specifically dedicated to the driver), or alternatively in a right-hand portion of the dashboard (for motor vehicles where the driver seats on the left-hand side).

The display device dedicated to the front passenger is generally used to display images or video sequences for entertaining the front passenger during journeys. Displaying such images or video sequences in the passenger compartment may however be problematic, such as because of the need for the driver to focus on driving.

### SUMMARY OF THE INVENTION

In this context, the invention provides a system comprising:
- a display device capable of generating a light beam having an adjustable angular extension (*e*.*g*. in the horizontal plane);
- a control unit configured to control the angular extension of the light beam depending on information relating to at least one occupant at least possibly viewing the display device.

The angular extension of the light beam generated by the display device may thus be adapted to as a function of an occupant or occupants of the passenger compartment to avoid problematic situations, such as distracting the driver by seeing a displayed content.

An occupant at least possibly viewing the display device is an occupant located in the passenger compartment of the vehicle at a position from where the occupant sees the display device if this occupant looks in the direction of the display device (*i.e.* there is no obstacle, such as a front seat, between the occupant's position and the display device). Said occupant may for example be the driver or a rear passenger.

In the present description, horizontal and vertical directions are considered in the usual conditions of use of the display device (*e.g*. in the passenger compartment of a vehicle), the screen of the display device lying in a substantially vertical plane and producing a light beam having main propagation direction that is substantially horizontal (the horizontal plane mentioned above being parallel to this horizontal propagation direction, possibly including this horizontal propagation direction).

The system may for instance comprise at least one sensor configured to provide the information relating to at least one occupant at least possibly viewing the display device.

According to a possible solution, said at least one sensor may be configured to detect an occupant at a predetermined location in the passenger compartment.

The control unit may then be configured to control said angular extension depending on a detection result provided by said at least one sensor.

According to a particular solution, the sensor may be a camera configured to capture an image of at least part of the passenger compartment.

The control unit may then be configured to process the captured image to determine a characteristic relating to an occupant and to control said angular extension depending on the determined characteristic.

In another particular embodiment, said at least one sensor may be a presence sensor such as a force sensor or a proximity sensor or a radar.

Said at least one sensor may include a plurality of presence sensors for instance a first presence sensor configured to detect a driver and a second presence sensor configured to detect a rear passenger.

In a particular embodiment, the plurality of presence sensors may involve different types of presence sensors (force sensor, proximity sensor or radar sensor).

In some embodiments, as exemplified below, both possible solutions may be combined, *i.e.* several sensors can be used (*e.g.* a camera and one or more presence sensors), each sensor providing either a detection result or a captured image used by the control unit to determine a characteristic of an occupant.

The characteristic mentioned above may for instance be the presence or absence of said occupant, or a direction of line of sight of said occupant (*e*.*g*. a direction of line of sight of the driver), or an age group of said occupant.

The control unit may for instance be configured to control the angular extension of the light beam generated by the display device to a first value when said information (and thus the characteristic mentioned above) indicates that the occupant is absent and to a second value when said information (and thus the characteristic mentioned above) indicates that the occupant is present, said second value being distinct from the first value (and in some embodiments smaller than the first value to obtain a reduction of angular extension when said occupant is present).

The control unit may also be configured to control the angular extension of the light beam generated by the display device to a third value when said information (and thus the characteristic mentioned above) indicates that the occupant belongs to a particular age group (*e*.*g*. when the occupant is a child) and to a fourth value when said information (and thus the characteristic mentioned above) indicates that the occupant does not belong to said particular age group (*e*.*g*. when the occupant is not a child), said fourth value being distinct from the third value (and in some embodiments larger than the third value to obtain a reduced angular extension when the occupant is a child).

The control unit may also be configured to control the angular extension of the light beam generated by the display device to a fifth value when said information indicates that a line of sight of the occupant (*e*.*g*. the driver) is directed towards the display device and to a sixth value when said information indicates that the line of sight of the occupant (*e*.*g.* the driver) is not directed towards the display device, said sixth value being distinct from the fifth value (and in some embodiments larger than the fifth value to offer a broader angular extension when the occupant, *e*.*g*. the driver, is not looking at the display device).

In a particular embodiment, the occupant may be a rear passenger and the control unit may be configured to control the angular extension of the display device to a seventh value when said information indicates that the rear passenger is absent and to an eighth value when said information indicates that the rear passenger is present, said eighth value being distinct from the seventh value (and in some embodiments smaller than the seventh value to provide confidentiality to the viewer of the display device when a rear passenger is present).

As shown in the following description, these various strategies can in practice be combined. Some angular extension values may then be common to distinct strategies: for instance, the third value mentioned above can be equal to the fifth value.

In the described examples, the light beam is directed towards a front passenger and/or the occupant mentioned above may be the driver or a rear passenger. The invention could however be used in other situations, for instance when the display device is located at the back of the front passenger seat and dedicated to a particular rear passenger, the system then considering information provided by a sensor and/or a characteristic relating to another rear passenger. The control unit could then for instance control a restricted angular extension of the light beam generated by the display device if the other passenger is determined to be a child.

The invention also provides a vehicle (*e.g*. a motor vehicle, such as a car) comprising a passenger compartment and the system proposed above.

The invention also provides a method implemented in a vehicle including a display device capable of generating a light beam having an adjustable angular extension, the method comprising a step of controlling the angular extension of the light beam depending on information relating to at least one occupant at least possibly viewing the display device.

Said at least one occupant may for example be the driver or a rear passenger.

Optional features proposed above in connection with the system may also be applied, individually or in possible combinations, to this method.

In particular, as explained above, as an additional step of the method, at least one sensor may provide the information relating to at least one occupant at least possibly viewing the display device.

The method may also include the following steps:
- capturing an image of at least part of the passenger compartment of the vehicle;
- processing the captured image to determine a characteristic of an occupant.

The angular extension of the light beam may then be controlled depending on this characteristic.

Other features and advantages of the embodiments of the present invention will be better understood upon reading of preferred embodiments thereof with reference to the appended drawings.

### BRIEF DESCRIPTION OF THE DRAWINGS

Figure 1 shows the main elements of a first possible embodiment of a system according to the invention;
Figure 2 shows the main elements of a second possible embodiment of a system according to the invention;
Figure 3 shows the main elements of a third possible embodiment of a system according to the invention;
Figure 4 shows a possible implementation of the display device used in the systems of Figures 1 to 3 in a first operating condition; and
Figure 5 shows the display device of Figure 4 in a second operating condition; and
Figure 6 schematically shows the possible arrangement of different persons and devices in the passenger compartment of a vehicle where an exemplary embodiment of the invention is implemented.

### DETAILED DESCRIPTION OF EXAMPLE(S)

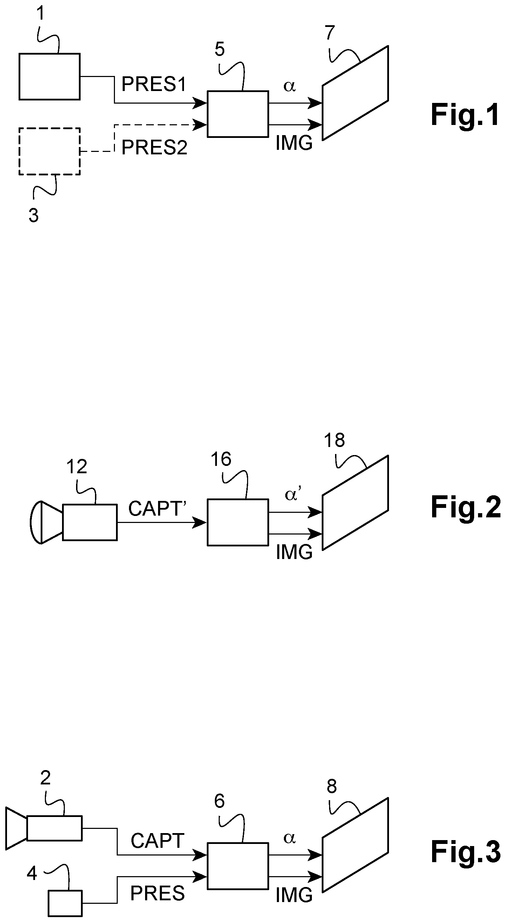

Figure 1 depicts a system comprising a first presence sensor 1, a control unit 5 and a display device 7.

In a variant, the system also comprises a plurality of presence sensors, such as a second presence sensor 3 in addition to the first presence sensor 1.

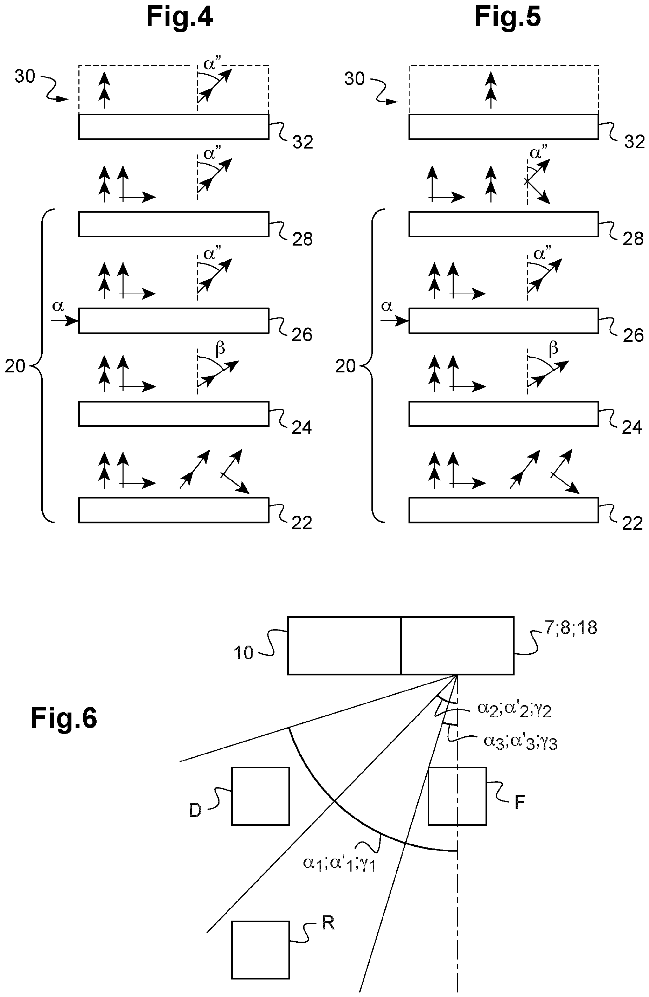

This system is placed in a motor vehicle (such as a car). As schematically shown in Figure 6, the passenger compartment of this car includes a dedicated location (*i*.*e*. a seat) for the driver D, a dedicated location (*i*.*e*. a seat) for the front passenger F and a back seat for one or several rear passengers R.

The display device 7 generates a light beam towards the location of the front passenger. Said differently, the display device 7 is dedicated for use by the front passenger. The display device 7 may display images or video sequences (sequences of images), such as movies.

The display device 7 is for instance located in the central portion of the dashboard of the motor vehicle.

In other embodiments, as in the example shown in Figure 6, the display device 7 may be located in the right-hand portion of the dashboard, in front of the front passenger (in motor vehicles where the driver is seated on the left-hand side).

In other embodiments, the display device 7 may be located in the left-hand portion of the dashboard, in front of the front passenger (in motor vehicles where the driver is seated on the right-hand side).

The display device 7 is possibly combined with another display device 10 meant to provide the driver with information relating to operation of the motor vehicle, such as a navigation map, climate functions, for instance. In this case, the display device 8 and the other display device 10 may be combined as a single screen viewed from the passenger compartment (although the display device 7 and the other display device may in practice be distinct display devices with different constructions), the display device 7 forming the right-hand part of this screen and the other display device 10 forming the left-hand part of this screen.

In an alternative embodiment, the display device 7 and the other display device 10 may form a single display device, wherein sole the angular extension of the light beam generated by the display device 7 may be controllable.

The display device 7 is designed such that the angular extension of the generated light beam (in the horizontal plane) may be controlled. An example of such a display device is described below referring to Figures 4 & 5.

The first presence sensor 1 is configured to detect whether a driver is present in the driver's seat or a passenger is present on the back seat at a location from which the passenger can observe the display device 7. The first presence sensor 1 is for instance a force sensor placed in the driver's seat or the back seat.

In a particular embodiment, two presence sensors 1, 3 are considered. The first presence sensor 1 is configured to detect whether a driver is present in the driver's seat. The second presence sensor 3 is configured to detect whether a passenger is present on the back seat at a location from which the passenger can observe the display device 7. In this goal, the second presence sensor 3 is for instance a force sensor placed in the back seat at a seating position from which the passenger can observe the display device 7.

In some embodiments, several presence sensors such as the second presence sensor 3 may be used to detect the possible presence of a passenger at a plurality of positions (the display device 7 being viewable by a passenger located at each of these positions). In such a manner, the plurality of presence sensors 1, 3 enables to determine the possible presence of a person in the driving seat and/or any of the back seats at a seating position from which the passenger can observe the display device 7.

In a more particular embodiment, at least each of the driver seat and any of the back seats at a seating position from which the passenger can observe the display device 7 comprises a presence sensor 1, 3.

In other embodiments, the first presence sensor 1 and/or the second presence sensor 3 may be a radar sensor configured to detect the presence of the driver, or a particular rear passenger, respectively. Any combination thereof may be considered.

In other embodiments, the first presence sensor 1 or the second presence sensor 3 may be a proximity sensor.

The control unit 5 is for instance an electronic control unit of the motor vehicle. Such a control unit 5 may include in practice a processor and at least one memory. The memory may store computer program instructions designed such that the processor performs the actions performed by the control unit 5 as described below.

The control unit 5 receives from the first presence sensor 1 an item of information PRES1 indicating whether a driver D is present in the driver's seat or a rear passenger R is present on the back seat at a location from which the passenger can observe the display device 7.

In a particular embodiment, the control unit 5 receives from the first presence sensor 1 an item of information PRES1 indicating whether a driver D is present in the driver's seat and from the second presence sensor 3 an item of information PRES2 indicating whether a rear passenger R is present at the concerned location on the back seat.

The control unit 5 sends to the display device 7 *(e.g.* via the data network mentioned above or via a data bus):
- data IMG defining the image (or a sequence of images) to be displayed by the display device 7;
- a piece of data α defining the requested angular extension (in the horizontal plane) of the light beam generated by the display device 7.

The control unit 5 is configured to determine the requested angular extension based on whether the driver is present (as determined using the first presence sensor 1) and/or based on whether a passenger is present on the back seat (as determined using the second presence sensor 3, or several such presence sensors in some embodiments).

The control unit 5 is thus configured to control the angular extension of the light beam generated by the display device 7 depending on the detection result provided by the first presence sensor 1 and/or the detection result provided by the second presence sensor 3.

According to a possible implementation (see Figure 6 which schematically illustrates a corresponding possible arrangement), the control unit 5 may determine the requested angular extension as follows:
- if the driver D is not present and no passenger R is present in the back seat, the requested angular extension is α₁;
- if the driver D is present and no passenger R is present in the back seat, the requested angular extension is α₂;
- if a passenger R is present in the back seat, the requested angular extension is α₃,
with α₁ > α₂ > α₃.

In some embodiments, α₃ is 18° or below (for instance α₃ is comprised between 15° and 18°) and/or α₂ is 30° or below (for instance α₂ is comprised between 18° and 30°°) and/or α₁ is 45° or more (for instance α₁ being comprised between 45° and 90°).

The angular extension of the light beam generated by the display 7 is thus controlled to switch between two distinct values:
- when the driver is present or absent, respectively;
- when a rear passenger is present or absent, respectively.

Using a large angular extension (*i*.*e*. a broad light beam) when neither the driver nor a rear passenger is present avoids a loss of intensity when the front passenger moves his/her head and thus provides a better comfort when watching the display device 7.

As the angular extension of the light beam generated by the display device 7 is restricted when a rear passenger is detected, the present implementation offers confidentiality to the front passenger with respect to the rear passengers. In other embodiments, other decision strategies with respect to the rear passengers can be used.

The proposed solution avoids that the driver may be distracted by the content displayed by the display device 7 by reducing the angular extension to α₂ when the driver is present.

As further explained below, controlling the display device 7 to provide an angular extension α₃ may correspond in some embodiments to a particular mode of operating of the display device 7 (generally called *"privacy mode"*)*.*

Figure 2 depicts a system comprising a camera 12 (here a camera of an internal monitoring system, or in-vehicle monitoring system, also called IMS camera, alternatively a DMS (Driver Monitoring System) camera), a control unit 16 and a display device 18.

This system is placed in a motor vehicle (such as a car). The passenger compartment of this car includes a dedicated location (*i*.*e*. a seat) for the driver, a dedicated location (*i*.*e*. a seat) for the front passenger and a back seat for one or several rear passengers.

As in the first embodiment described above, the display device 18 generates a light beam towards the location of the front passenger. Said differently, the display device 18 is dedicated for use by the front passenger.

As explained above in connection with the first embodiment, the display device 18 may be located in the central portion of the dashboard of the motor vehicle, possibly combined with another display device meant to provide the driver with information relating to operation of the motor vehicle (such as a navigation map, climate functions, for instance), or located in the right-hand portion (or alternatively the left-hand portion) of the dashboard, in front of the front passenger.

The display device 18 is designed such that the angular extension of the generated light beam (in the horizontal plane) may be controlled. An example of such a display device is described below referring to Figures 4 & 5.

The camera 12 is configured to capture (*e.g*. at regular intervals) images of the passenger compartment covering the possible locations of all the occupants.

Data CAPT' representing the image captured at a given time (which is considered in the following) is transmitted from the camera 12 to the control unit 16 (for instance via a data network, such as a LIN).

The control unit 16 (*e.g.* an electronic control unit of the motor vehicle, possibly implemented by a processor executing a computer program stored in a memory connected to the processor) receives the data CAPT' and processes the image represented by the data CAPT' in order to determine:
- whether the driver is present;
- if the driver is present, the direction of the line of sight of the driver;
- whether at least a rear passenger is present at a location from where this rear passenger may see the display device 8;
- if such a rear passenger is present, whether this rear passenger belongs to a particular age group (here: whether this rear passenger is a child).

A child may for example be detected based on image processing using a classifier with a learning model. The image may be acquired by the camera 12, which may be a driver monitoring system DMS or an interior monitoring system IMS.

Alternatively, it is known to use a radar and to process the data using a classifier with a learning model. The system may monitor the heartbeat rate or breathing rate to acknowledge if the occupant is a child or an adult.

The control unit 16 determines an angular extension depending on the various results obtained by processing the image represented by the data CAPT' as mentioned above, thus here depending on whether the driver is present and/or depending on the direction of the line of sight of the driver and/or whether a rear passenger is present at a location from where this rear passenger may see the display device 18 and/or whether this rear passenger is a child.

According to a possible implementation (see Figure 6 which schematically illustrates a corresponding possible arrangement), the control unit 16 may determine the angular extension as follows:
- if the driver D is not present and no child is present as a rear passenger R at a location where he/she may see the display device 18, the requested angular extension is α'₁;
- if the driver D is present and has a line of sight not directed towards the display device 8, and no child is present as a rear passenger R at a location where he/she may see the display device 18, the requested angular extension is α'₂;
- if the driver D is present and has a line of sight directed towards the display device 8, or if a child is present as a rear passenger R at a location where he/she may see the display device 18, the requested angular extension is α'₃,
with α'₁ > α'₂ > α'₃.

In some embodiments, α'₃ is 18° or below (for instance α'₃ is comprised between 15° and 18°) and/or α'₂ is 30° or below (for instance α'₂ is comprised between 18° and 30°,) and/or α'₁ is 45° or more (for instance α'₁ being comprised between 45° and 90°).

In a particular embodiment, the angles α'₁, α'₂, α'₃ are identical to the angles α₁, α₂, α₃ mentioned above in connection with the embodiment of Figure 1.

The control unit 16 sends to the display device 18 (*e.g.* via the data network mentioned above or via a data bus):
- data IMG defining the image to be displayed by the display device 18 at the concerned moment;
- a piece of data α defining the determined angular extension so that the light beam generated by the display device 18 has this angular extension in the horizontal plane.

Said differently, the angular extension of the light beam generated by the display 18 is controlled by the control unit 16 to switch between two distinct values:
- depending on whether the driver is present or absent, respectively;
- depending on whether a rear passenger belongs to a particular age group (here childhood) or not, respectively;
- depending on whether the line of sight of the driver is directed towards the display 18 or not, respectively.

Thus, the light beam has a restricted angular extension (α'₃) when a child is seated in the back seat and may see the display device 18, such that this child is not covered by the light beam and cannot therefore watch the displayed content, which may be inappropriate for a child. This restricted angular extension is also used when the driver looks towards the display device 18 to make sure that the driver cannot be distracted by the content displayed by the display device 18.

However, when no child is in a position to see the display device 18 and when the driver is not specifically looking at the display device 18, the light beam has a medium angular extension (α'₂) which makes it possible for the front passenger to move the head without major loss in image intensity (thus a more comfortable viewing experience for the front passenger) and possibly for some rear passengers at least (who are old enough) to watch the content displayed by the display device 18.

Lastly, when no child is in a position to see the display device 18 and when there is no one in the driver's seat, the light beam has a broad angular extension (α'₁) for maximum comfort.

In other embodiments, other strategies for determining the angular extension of the light beam of the display device 18 depending on information provided by the camera 12 to the control unit 16 may be chosen. For instance, for the sake of confidentiality of information displayed by the display device 18, the restricted angular extension may (α'₃) may be selected as soon as a rear passenger is detected (irrespective of whether this rear passenger is a child or not, *i.e.* irrespective of the age group of the detected rear passenger).

As mentioned regarding the first embodiment and as further explained below, controlling the display device 18 to provide a restricted angular extension α'₃ may correspond in some embodiments to a particular mode of operating of the display device 18 (generally called *"privacy mode*")*.*

Figure 3 depicts a system comprising a camera 2 (here a camera of a driver monitoring system DMS or an interior monitoring system IMS), a presence sensor 4, a control unit 6 and a display device 8.

This system is placed in a motor vehicle (such as a car). The passenger compartment of this car includes a dedicated location (*i.e.* a seat) for the driver, a dedicated location (*i.e.* a seat) for the front passenger and a back seat for one or several rear passengers.

The display device 8 generates a light beam towards the location of the front passenger. Said differently, the display device 8 is dedicated for use by the front passenger. The display device 8 may display images or video sequences (sequences of images), such as movies.

The display device 8 is for instance located in the central portion of the dashboard of the motor vehicle and possibly combined with another display device meant to provide the driver with information relating to operation of the motor vehicle, such as a navigation map, climate functions, for instance. In this case, the display device 8 and the other display device may be combined as a single screen viewed from the passenger compartment (although the display device 8 and the other display device are distinct display devices with different constructions), the display device 8 forming the right-hand part of this screen and the other display device forming the left-hand part of this screen.

In other embodiments, the display device 8 may be located in the right-hand portion of the dashboard, in front of the front passenger (in motor vehicles where the driver is seated on the left-hand side).

In other embodiments, the display device 8 may be located in the left-hand portion of the dashboard, in front of the front passenger (in motor vehicles where the driver is seated on the right-hand side).

The display device 8 is designed such that the angular extension of the generated light beam (in the horizontal plane) may be controlled. An example of such a display device is described below referring to Figures 4 & 5.

The presence sensor 4 is configured to detect whether a passenger is present on the back seat at a location from which the passenger can observe the display device 8. In this goal, the presence sensor 4 is for instance a force sensor placed in the back seat at a seating position from which the passenger can observe the display device 8.

In some embodiments, several presence sensors 4 may be used to detect the possible presence of a passenger at a plurality of positions (the display device 8 being viewable by a passenger located at each of these positions). In such a manner, this plurality of presence sensor enables to determine the possible presence of a person in any of the back seats at a seating position from which the passenger can observe the display device 8.

In other embodiments, the presence sensor 4 may be a radar sensor configured to detect the presence of a particular rear passenger.

In other embodiments, the presence sensor 4 may be a proximity sensor.

The control unit 6 is for instance an electronic control unit of the motor vehicle. Such a control unit 6 may include in practice a processor and at least one memory. The memory may store computer program instructions designed such that the processor performs the actions performed by the control unit 6 as described below.

The camera 2 is placed and oriented so as to observe the region where the head of the driver is located (when the driver is present and in a driving position). For example, the camera may be a DMS camera and/or an IMS camera, which may already be present in the vehicle.

Images CAPT captured at regular intervals by the camera 2 are transmitted to the control unit 6 (*e.g*. via a vehicle data network such as a LIN, LIN standing for *"Local Interconnect Network*").

By processing the images CAPT, the control unit 6 is adapted to determine (*e.g.* at regular intervals, one of which is considered in the following):
- whether the driver is present on the driver's location (*i*.*e*. the driver's seat);
- if the driver is present, the direction of the line of sight of the driver.

The control unit 6 receives from the presence sensor 4 an item of information PRES indicating whether a passenger is present at the concerned location on the back seat.

The control unit 6 sends to the display device 8 *(e.g.* via the data network mentioned above or via a data bus):
- data IMG defining the image (or a sequence of images) to be displayed by the display device 8;
- a piece of data α defining the requested angular extension (in the horizontal plane) of the light beam generated by the display device 8.

The control unit 6 is configured to determine the requested angular extension based on whether the driver is present (as determined based on the image CAPT) and optionally based on the direction of the line of sight of the driver (as determined based on the image CAPT) and/or based on whether a passenger is present on the back seat (as determined using the presence sensor 4, or several such presence sensors in some embodiments).

The control unit 6 is thus configured to control the angular extension of the light beam generated by the display device 8 depending on the detection result provided by the presence sensor 4 and/or based on at least one characteristic relating to the driver and determined by the control unit 6 by processing the image CAPT.

According to a possible implementation (see Figure 6 which schematically illustrates a corresponding possible arrangement), the control unit 6 may determine the requested angular extension as follows:
- if the driver D is not present and no passenger R is present in the back seat, the requested angular extension is γ₁;
- if the driver D is present and has a line of sight not directed towards the display device 8, and no passenger R is present in the back seat, the requested angular extension is γ₂;
- if the driver D is present and has a line of sight directed towards the display device 8, or if a passenger R is present in the back seat, the requested angular extension is γ₃,
with γ₁ > γ₂ > γ₃.

In some embodiments, γ₃ is 18° or below (for instance γ₃ is comprised between 15° and 18°) and/or γ₂ is 30° or below (for instance γ₂ is comprised between 18° and 30°) and/or γ₁ is 45° or more (for instance γ₁ being comprised between 45° and 90°).

The angular extension of the light beam generated by the display 8 is thus controlled to switch between two distinct values:
- when the driver is present or absent, respectively;
- when a rear passenger is present or absent, respectively;
- when the line of sight of the driver is directed towards the display or not, respectively.

Using a large angular extension *(i.e.* a broad light beam) when neither the driver nor a rear passenger is present avoids a loss of intensity when the front passenger moves his/her head and thus provides a better comfort when watching the display device 8.

As the angular extension of the light beam generated by the display device 8 is restricted when a rear passenger is detected, the present implementation offers confidentiality to the front passenger with respect to the rear passengers. In other embodiments, other decision strategies with respect to the rear passengers can be used.

The proposed solution avoids that the driver may be distracted by the content displayed by the display device 8 by reducing the angular extension to γ₂ when the driver is present and by reducing the angular extension further (to γ₃) when the driver's line of sight is directed towards the display device 8.

As further explained below, controlling the display device 8 to provide an angular extension γ₃ may correspond in some embodiments to a particular mode of operating of the display device 8 (generally called *"privacy mode"*)*.*

Figures 4 & 5 show an exemplary display device that can be used as the display device of Figures 1 to 3.

This display device includes a backlighting module 20 and an LCD panel 30.

The backlighting module includes 20 (in this order along the path of light) a light source 22 (for instance using light emitting diodes), a polarised sensitive element 24, a view angle element 26 and a liquid crystal cell 28.

The LCD panel 30 includes an input (linear) polariser film 32. Other details of the LCD panel 30, including liquid crystal cells in a matrix structure and an output polariser film, are not described here for the sake of conciseness.

The input polariser film 32 transmits only light having a given (linear) polarisation, here p-polarised light, and filters out *(i.e.* in practice absorbs or reflects) light having a polarisation orthogonal to the given polarisation, here s-polarised light.

The light transmitted by the input polariser film 32 (here the p-polarised light) is then processed in a conventional manner by subsequent elements (layers) of the LCD panel to form an image.

Figure 4 shows a situation where the liquid crystal cell 28 does not alter the polarisation of light, while Figure 5 shows a situation where the liquid crystal cell 28 changes the polarisation of light (transforming p-polarized light into s-polarized light and s-polarized into p-polarized light).

In Figures 4 & 5, p-polarized light is represented by a double arrow, while s-polarized light is represented by two perpendicular arrows. Furthermore, the direction of the double arrow (for p-polarized light), or the direction of the left-hand arrow (for s-polarized light), schematically represents the direction of light (here in the horizontal plane, corresponding to the plane of the drawings, the display device extending substantially in a vertical plane in the present example).

As schematically shown in Figures 4 & 5 using these representations, the light source 22 emits non-polarized light in a variety of directions.

In the example shown in Figures 4 & 5, the polarised sensitive element 24 receives light emitted by the light source 22. A light control film *(e.g.* as proposed in document JP 2006-138 996 or document JP 2006-195 634) may for instance be used as the polarised sensitive element 24.

The polarised sensitive element 24 filters out light having the polarisation orthogonal to the given polarisation (here s-polarised light) having a tilted orientation with respect to a main axis of propagation of light (which main axis is here perpendicular to the plane of extension of the light source 22). For instance, rays of s-polarised light forming an angle of more than a predetermined value ε (in the horizontal plane) are not transmitted through the polarised sensitive element 24. In the present example where Figure 5 corresponds to the privacy mode as explained below and this privacy mode is used to obtain the reduced angular extension (see angles α₃, α'₃ and γ₃ above), this predetermined value ε is 18° or below (for instance comprised between 15° and 18°).

Thus, the polarised sensitive element 24 transmits only:
- light oriented along the main propagation axis (whatever its polarisation, *i.e.* both s-polarised light and p-polarised light) and
- p-polarised light having a tilted orientation (here forming an angle larger than ε) with respect to the main propagation axis.

Besides, the tilted orientation of the p-polarised light transmitted by the polarised sensitive element 24 is limited in practice to an angle β (with respect to the main propagation axis and in this horizontal plane, with β > ε), due to the angular extension of the light source in practice and/or due to the polarised sensitive element 24 possibly also filtering out p-polarised light forming an angle greater than β with respect to the main propagation axis. The value of β is for instance here comprised between 45° and 70°.

In the example shown in Figures 4 & 5, the view angle element 26 receives light from the polarised sensitive element 24.

The view angle element 26 is configured to influence the intensity of light depending on the orientation of incoming light with respect to the main propagation axis, in a manner that depends on an electrical signal (e.g. a voltage) applied to the view angle element 26.

The view angle element 26 may for instance be a foil with optical guiding structures (or, alternatively a liquid crystal cell) which, depending on the voltage applied, give the light a preferred direction of propagation.

In the present example, the view angle element 26 transmits only light rays forming an angle smaller than a limit angle α" that is variable as a function of the electrical signal applied (this electrical signal being controlled by the piece of data α received from the control unit 6, 16 in the embodiments of Figures 1 to 3).

As already mentioned, the liquid crystal cell 28 is inactive in the situation shown in Figure 4 and does not therefore influence the incoming light (emerging from view angle element 26 in the present case).

Thus, in this situation, as shown in Figure 4, light output from the backlighting module 20 includes:
- light having the polarisation orthogonal to the given polarisation mentioned above (here s-polarised light) with rays extending substantially along the main propagation axis *(i.e.* in practice forming an angle less than ε than with respect to the main propagation axis, here in the horizontal plane);
- light having the given polarisation (here p-polarised light) with rays forming an angle less than the limit angle α", thus including tilted rays, with respect to the main propagation axis.

As explained above, the limit angle α" can be varied depending on the electrical signal applied to the view angle element 26.

As already indicated, only light having the given polarisation (here p-polarised light) is transmitted through the input polariser film 32 of the LCD panel 30 and is used to form the light beam generated by the LCD panel 30, *i.e.* by the display device.

Thus, in the situation of Figure 4, light rays transmitted through the polariser film 32 include light rays forming an angle having a value up to the (adjustable) limit angle α" (with respect to the main propagation axis) and the light beam generated by the display device thus has an angular extension variable as a function of the electrical signal applied to the view angle element 26 (this electrical signal depending on the data α received from the control unit 6,16).

Conversely, the liquid crystal cell 28 is active in the situation shown in Figure 5 such that p-polarised light (emerging from the view angle element 26 in the present case) is transformed into s-polarised light and s-polarised light (emerging from the view angle element 26 in the present case) is transformed into p-polarised light.

Thus, in the situation shown in Figure 5, light output from the backlighting module 20 includes:
- light having the polarisation orthogonal to the given polarisation (here s-polarised light) with rays forming an angle less than the limit angle α", thus including tilted rays, with respect to the main propagation axis;
- light having the given polarisation (here p-polarised light) with rays extending substantially along the main propagation axis (*i.e.* in practice forming an angle less than ε with respect to the main propagation axis, here in the horizontal plane).

As light having the given polarisation (here p-polarised light) is transmitted through the input polariser film 32 of the LCD panel 30 and is used to form the light beam generated by the LCD panel 30 (*i.e.* by the display device), only light rays extending substantially along the main propagation axis (or in practice forming an angle of less than ε with respect to the main propagation axis) are transmitted through the polariser film 32 and the light beam generated by the display device thus has a small angular extension. This situation corresponds to a privacy mode of operation of the display device.

As the view angle element 26 modulates the intensity of light depending on its orientation and does not affect, or depends on, polarisation of light, according to possible variations, the view angle element 26 could be placed (*i*.*e*. interposed) between the light source and the polarized sensitive element, or could be placed after the liquid crystal cell (following the path of light), *i.e.* could be interposed in this latter case between the liquid crystal cell and the LCD panel.

The display device just described with reference to Figures 4 & 5 may for instance be used as follows in connection with specific implementations described above and involving three possible angular extensions (α₁, α₂, α₃ or α'₁, α'₂, α'₃ or γ₁, γ₂, γ₃):
- the restricted angular extension can be obtained by controlling the display device in the privacy mode (*i.e.* the liquid crystal cell 28 is controlled to alter polarisation, as shown in Figure 5, when the piece of data α received from the control unit 6, 16 corresponds to the value α₃ or α'₃ or γ₃);
- the medium and broad angular extensions can be obtained by controlling the angular extension thanks to the electrical signal applied to the view angle element 26 (*i.e.* when the piece of data α received from the control unit 6, 16 corresponds to any of values α₁ and α₂, or α'₁ and α'₂, or γ₁ and γ₂, the liquid crystal cell 28 is controlled not to alter polarisation, as shown in Figure 4, and an electrical signal, *e.g*. a voltage, depending on the received piece of data α, is applied to the view angle element 26).

## Claims

1. A system comprising:
- a display device (7; 8; 18) capable of generating a light beam having an adjustable angular extension;
- a control unit (5; 6; 16) configured to control the angular extension of the light beam depending on information (PRES1; PRES2; CAPT; PRES; CAPT') relating to at least one occupant at least possibly viewing the display device (8; 18).

2. A system according to claim 1, wherein the system further comprises at least one sensor (1, 3; 2, 4; 12) configured to provide the information (CAPT; PRES; CAPT') relating to at least one occupant at least possibly viewing the display device (8; 18).

3. A system according to claim 2, wherein said at least one sensor (1, 3; 2, 4; 12) is configured to detect an occupant at a predetermined location in a passenger compartment and wherein the control unit (6) is configured to control said angular extension depending on a detection result (PRES1; PRES2; CAPT; PRES, CAPT') provided by said at least one sensor (1, 3; 2, 4; 12).

4. A system according to claim 2 or 3, wherein said at least one sensor (1, 3; 4) is a presence sensor such as a force sensor or a proximity sensor or a radar.

5. A system according to any of claims 1 to 4, wherein said at least one sensor includes a first presence sensor (1) configured to detect a driver and a second presence sensor (3) configured to detect a rear passenger.

6. A system according to claim 2 or 3, wherein said least one sensor (2; 12) is a camera configured to capture an image (CAPT; CAPT') of at least part of the passenger compartment and wherein the control unit (6; 16) is configured to process the captured image (CAPT; CAPT') to determine a characteristic relating to an occupant and to control said angular extension depending on the determined characteristic.

7. A system according to claim 6, wherein the characteristic is the presence or absence of said occupant.

8. A system according to claim 6, wherein the characteristic is a direction of line of sight of said occupant.

9. A system according to claim 6, wherein the characteristic is an age group of said occupant.

10. A system according to any of claims 1 to 9, wherein the control unit (5; 6; 16) is configured to control the angular extension of the light beam generated by the display device (7; 8; 18) to a first value when said information (PRES1 ; PRES2; CAPT; PRES; CAPT') indicates that the occupant is absent and to a second value when said information (PRES1; PRES2; CAPT; PRES; CAPT') indicates that the occupant is present, said second value being distinct from the first value.

11. A system according to any of claims 1 to 10, wherein the control unit (5; 6; 16) is configured to control the angular extension of the light beam generated by the display device (7; 8; 18) to a third value when said information (PRES1; PRES2; CAPT; PRES; CAPT') indicates that the occupant belongs to a particular age group and to a fourth value when said information (PRES1; PRES2; CAPT; PRES; CAPT') indicates that the occupant does not belong to said particular age group, said fourth value being distinct from the third value.

12. A system according to any of claims 1 to 11, wherein the control unit (5; 6; 16) is configured to control the angular extension of the light beam generated by the display device (7; 8; 18) to a fifth value when said information (PRES1; PRES2; CAPT; PRES; CAPT') indicates that a line of sight of the occupant is directed towards the display device (7; 8; 18) and to a sixth value when said information (PRES1; PRES2; CAPT; PRES; CAPT') indicates that the line of sight of the occupant is not directed towards the display device (7; 8; 18), said sixth value being distinct from the fifth value.

13. A system according to any of claims 1 to 12, wherein the occupant is a rear passenger and wherein the control unit (5; 6; 16) is configured to control the angular extension of the light beam generated by the display device (7; 8; 18) to a seventh value when said information (PRES1; PRES2; CAPT; PRES; CAPT') indicates that the rear passenger is absent and to an eighth value when said information (PRES1; PRES2; CAPT; PRES; CAPT') indicates that the rear passenger is present, said eighth value being distinct from the seventh value.

14. A system according to any of claims 1 to 12, wherein the light beam is directed towards a front passenger and wherein the occupant is a driver or a rear passenger.

15. A method implemented in a vehicle including a display device (7; 8; 18) capable of generating a light beam having an adjustable angular extension, the method comprising:
- a step of controlling the angular extension of the light beam depending on information (PRES1; PRES2; CAPT; PRES; CAPT') relating to at least one occupant at least possibly viewing the display device (8; 18).
